# EUROPÄISCHE PATENTSCHRIFT

(11) **EP 0 914 715 B1**
(45) Veröffentlichungstag und Bekanntmachung des Hinweises auf die Patenterteilung: **04.06.2003**
(21) Anmeldenummer: 98919251.3
(22) Anmeldetag: 09.04.1998
(51) Int. Cl.: H03L 7/113, H03L 7/099, H03L 7/16

(54) **VERFAHREN UND ANORDNUNG ZUM EINRASTEN EINES YIG-OSZILLATORS**
PROCESS AND DEVICE FOR LOCKING-IN A YIG-TUNED OSCILLATOR
PROCEDE ET DISPOSITIF POUR SYNCHRONISER UN OSCILLATEUR YIG

(30) Priorität: 22.04.1997 DE 19716776
(43) Veröffentlichungstag der Anmeldung: 12.05.1999
(73) Patentinhaber: EADS Deutschland GmbH, 81663 München (DE)
(72) Erfinder: SCHEFFOLD, Bruno, D-88299 Leutkirch (DE)
(74) Vertreter: Meel, Thomas
(86) Internationale Anmeldenummer: EP9802102
(87) Internationale Veröffentlichungsnummer: WO98048513

(56) Entgegenhaltungen:
- GB-A- 2 290 184
- US-A- 4 459 560
- US-A- 4 792 768
- US-A- 4 890 071
- SUMMERS J B ET AL: "HIGH-SPECTRAL-PURITY FREQUENCY SYNTHESIS IN A MICROWAVE SIGNAL GENERATOR" HEWLETT-PACKARD JOURNAL., Bd. 40, Nr. 5, 1.Oktober 1989, PALO ALTO US, Seiten 37-41, XP000087211

## Beschreibung

Die Erfindung betrifft ein Verfahren zum Einrasten einer Phasenregelschleife (PLL) um einen YIG-Oszillator gemäß dem Oberbegriff des Patentanspruchs 1 sowie eine Anordnung zur Durchführung des Verfahrens gemäß dem Oberbegriff des Patentanspruchs 9.

YIG-Oszillatoren werden zur Unterdrückung des trägernahen Phasenrauschens üblicherweise mittels einer PLL an einen langzeit-frequenzstabilen Quarzoszillator angebunden. Bei einem Frequenzwechsel hat die relativ schmalbandige PLL mit ihrem geringen Fangbereich Probleme auf eine neue Betriebsfrequenz einzurasten.

Es ist bekannt (Floyd M.Gardner, Phaselock Techniques, Wiley & Sons, New York, 1979, Seite 84-87), das Einrasten der PLL mittels einer zusätzlichen Frequenzregeschleife zu unterstützen. In der Frequenzregelschleife ist ein Fre-quenzdiskriminator zur Ermittlung der Regelabweichung eingesetzt. Sobald die Frequenz des YIG-Oszillators mittels der Frequenzregelschleife in den Fangbereich der PLL geführt ist, wird der YIG-Oszillator fast ausschließlich von der PLL kontrolliert. Die Frequenzregelschleife kann, falls gewünscht, dann abgeschaltet werden (Gardner; wie o.a.)YIG-Oszillatoren können einer Alterung unterliegen und eine Hysterese aufweisen,wodurch eine Steuerung der Oszillatorfrequenz über den Hauptspulenstrom des YIG-Oszillators in seiner Genauigkeit beeinträchtigt ist. Diese Steuerung ist bei einem Frequenzwechsel erforderlich, um mit der Oszillatorfrequenz wieder in den Fangbereich der Regelschleifen zu kommen.

Aufgabe der Erfindung ist es ein Einrastverfahren für einen YIG-Oszillators zu schaffen, das eine Alterung und Hysterese des YIG-Oszillators berücksichtigt. Der Erfindung liegt außerdem die Aufgabe zugrunde, eine Anordnung zur Durchführung des Verfahrens anzugeben.

Diese Aufgabe wird erfindungsgemäß durch die in den Patentansprüchen 1 und 9 angebenen Merkmale gelöst.

Weiterbildungen sind in den Unteransprüchen angegeben.

Die Erfindung verwendet in bekannter Weise als Einrasthilfe für die relativ schmalbandige PLL eine Frequenzregelschleife. Zur Überwindung von Ungenauigkeiten bei der Voreinstellung des YIG-Oszillators auf den Fangbereich der Frequenzregelschleife, die auf eine Alterung und die Hysterese des YIG-Oszillators zurückzuführen sind, wird bei einem Frequenzwechsel zusätzlich mittels eines Mikroprozessors eine sich auf den Strom der Hauptabstimmspule des YIG-Oszillators auswirkende Fangroutine gestartet, welche diese Ungenauigkeiten berücksichtigt.

Die erfindungsgemäßen Lösungen ermöglichen in Zusammenwirkung mit der Frequenzregelschleife und der PLL ein sicheres und rasches Einrasten der Istfrequenz auf eine neue Betriebsfrequenz. In den Unteransprüchen sind vorteilhafte Fangroutinen für eine alternative Anbindung des YIG-Oszillators an einen oder an zwei Quarzoszillatoren angegeben. Weiterhin ist angegeben, wie mit der Erfindung auch vorteilhaft eine Drift des auf eine Betriebsfrequenz eingerasteten YIG-Oszillators kompensiert werden kann. Eine vorteilhafte Weiterbildung der Erfindung betrifft die Abspeicherung des auf Alterung beruhenden Offsets für eine schnellere Ausführung von nachfolgende Einrastvorgängen.

Die Erfindung kann auf einen YIG-Oszillator angewendet werden, der als rauscharme Mikrowellensignalquelle benutzt wird und mit zwei langzeit-frequenzstabilen Quarzoszillatoren einen großen Frequenzabstimmbereich, z.B. das gesamte X-Band abdeckt. Dabei wirkt in der PLL einer der Quarzoszillatoren auf einen einstellbaren Frequenzvervielfacher und selektiert aus dem relativ breiten Abstimmbereich des YIG-Oszillators mit f1 das gewünschte Frequenzsegment der Aufbereitung und der andere Quarzoszillator bestimmt über einen Direkten Digitalen Synthesizer (DDS) die Ausgangsfrequenz f2 innerhalb dieses Segments. Der YIG-Oszillator schwingt in dieser Schaltung an seinem Ausgang mit der Kombinationsfrequenz f_{YIG} = n ∗ f1 + f2.

Anhand der Zeichnung werden Ausführungsbeispiele der Erfindung näher erläutert.
Fig.1 zeigt eine Anordnung zur Durchführung des erfindungsgemäßen Einrastverfahrens, in welcher der YIG-Oszillator an zwei Quarzoszillatoren angebunden ist,
Fig.2 zeigt den Ablauf eines erfindungsgemäßen Einrastverfahrens, das bewußt oberhalb der neuen Betriebsfrequenz f_{SOLL} startet,
Fig.3 zeigt den Ablauf eines erfindungsgemäßen Einrastverfahrens, wobei die Fangroutine mit einem Spulenstrom (I_{SP}) startet, der gemäß der typ-spezifischen Kennlinie des YIG -Oszillators der neuen Betriebsfrequenz f SOLL zugeordnet ist,
Fig.4 zeigt den Ablauf eines erfindungsgemäßen Einrastverfahrens mit einer zusätzlichen Abstimmroutine für die FM-Spule und
Fig.5 zeigt eine Anordnung zur Durchführung der erfindungsgemäßen Verfahren, in welcher der YIG-Oszillator nur an einen Quarzoszillator angebunden ist.

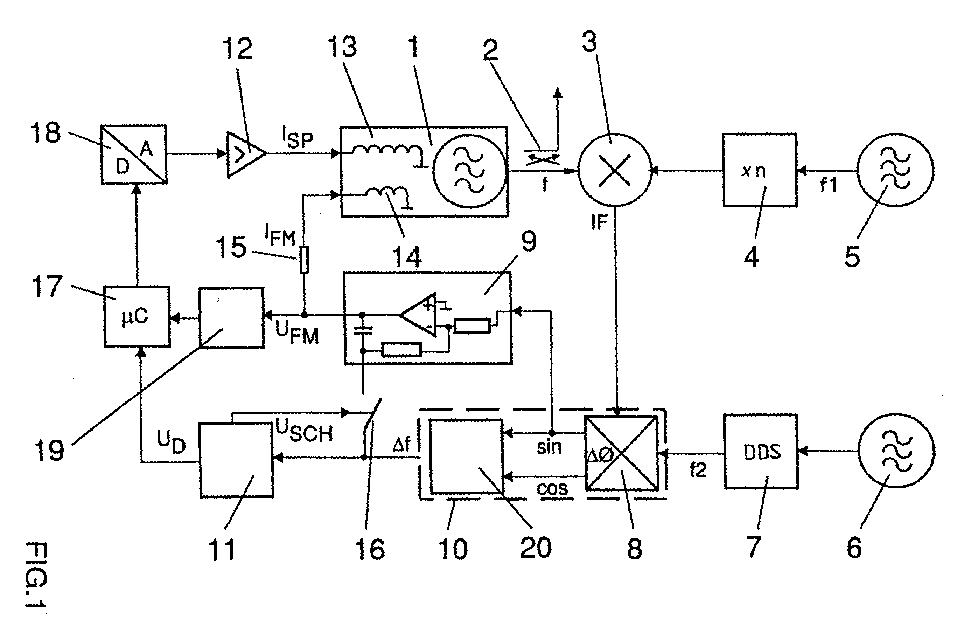

Die in Fig.1 gezeigte Anordnung besteht aus dem YIG-Oszillator 1 mit einer Hauptabstimmspule 13 und einer FM-Spule 14, aus einer Auskoppelstufe 2, einem Frequenzmischer 3, einem Frequenzvervielfacher 4, zwei Quarzoszillatoren 5 und 6, einem Direkten Digitalen Synthesizer 7, einem Frequenzdiskriminator 10 mit einem Phasenkomparator 8 und einer Ausgangsstufe 20, Schleifenfilter 9, ohmschen Widerstand 15, PLL-LOCK-Detektor 11, FM-Spulenstromüberwacher 19, Analogschalter 16, Mikroprozessor 17, D-A-Wandler 18 und einem U-I-Konverter 12.

Der YIG-Oszillator 1 verfügt über zwei Eingänge zur Frequenzabstimmung. Mit der Hauptabstimmspule 13 läßt sich der gesamte Schwingbereich des YIG-Oszillators durchstimmen, daneben erlaubt die FM-Spule 14 eine Feinabstimmung der Oszillatorfrequenz.

Zum Zwecke der Unterdrückung des trägernahen Phasenrauschens ist der YIG-Oszillator 1 an die beiden langzeit-frequenzstabilen Quarzoszillatoren 5 und 6 angebunden. Dabei ist das Ausgangssignal des YIG-Oszillators 1 als Istwert auf den Frequenzmischer 3 gegeben, nachdem vorher in der Auskoppelstufe 2 eine Abzweigung des Ausgangssignales als Nutzsignal erfolgt ist. Der Quarzoszillator 5 liefert den Sollwert f1, der, nach Vervielfachung um einen vorgebbaren Faktor n in dem Frequenzvervielfacher 4, ebenfalls auf den Frequenzmischer 3 gegeben ist und mit dem Istwert das Schwebungssignal IF am Ausgang des Frequenzmischers 3 bildet. Das Ausgangssignal des Frequenzmischers 3 ist auf den Phasenkomparator 8 des Frequenzdiskriminators 10 gegeben und wird dort mit der Ausgangsfrequenz (f2) des Direkten Digitalen Synthesizers (DDS) 7 verglichen, der von dem zweiten Quarzoszillator 6 gespeist ist. Die Ausgangsfrequenz des DDS ist von außen vorgebbar.

In dem Frequenzdiskriminator 10 ist der eingangsseitige Phasenkomparator 8 in bekannter Weise (Gardner; wie o.a.) in zwei Quadraturkomponenten aufgespalten, wobei der In-Phase-Detektor gleichzeitig als Phasenkomparator für die PLL dient. Dazu ist die In-Phase-Komponente sin nach der Phasendetektion aus dem Frequenzdiskriminator 10 heraus abgezweigt und auf den Eingang des Schleifenfilters 9 gegeben.

Die detektierten Quadraturkomponenten sin und cos werden in der Ausgangsstufe 20 des Frequenzdiskriminators 10 nach einer Filterung und einer Differenzierung einer der beiden Komponenten miteinander multipliziert und das Signalprodukt bildet das Ausgangssignal Δf des Frequenzdiskriminators 10. Dieses Ausgangsignal Δf ist bis auf einen vernachlässigbaren Rippel im wesentlichen ein Gleichspannungssignal, dessen Pegel proportional zur Differenz der in den Phasenkomparator 8 eingespeisten Frequenzen ist. Es ist auf den Eingang eines PLL-LOCK-Detektors 11 gegeben und parallel dazu über einen Analogschalter 16 in den Gegenkopplungszweig des mit einem rauscharmen Operationsverstärkers als Integrator ausgebildeten Schleifenfilters 9 eingespeist. Der Analogschalter 16 ist von dem PLL-LOCK-Detektor 11 aus mit einem Stellsignal U_{SCH} steuerbar.

Das Schleifenfilter 9 gibt die Ausgangsspannung U_{FM} ab. Diese Ausgangsspannung ist, umgeformt über einen ohmschen Widerstand 15, als Spulenstrom I_{FM} direkt in die FM-Spule 14 des YIG-Oszillators 1 eingespeist und parallel dazu auf einen FM-Spulenstromüberwacher 19 gegeben.

Die Hauptabstimmspule 13 des YIG-Oszillators 1 ist von einem steuerbaren UI-Konverter 12 mit einem Spulenstrom I_{SP} versorgt. Der U-I-Konverter 12 ist über einen D-A-Wandler 18 von dem Mikroprozessor 17 gesteuert.

Der Mikroprozessor 17 wertet das Ausgangssignal U_{D} des PLL-LOCK-Detektors 11 und das Ausgangssignal des FM-Spulenstromüberwachers 19 aus.

Für einen Frequenzwechsel werden die von den Quarzoszillatoren 5,6 abgegebenenFrequenzsignale mittels des Frequenzvervielfachers 4 bzw. mittels des Direkten Digitalen Synthesizers 7 auf die neue Betriebsfrequenz f_{SOLL} eingestellt. Da die neue Betriebsfrequenz f_{SOLL} überlicherweise außerhalb des Fangbereiches der PLL liegt, rastet diese aus. Das dabei auftretende Ausgangssignal ΔΦ des Phasenkomparators 8 führt zu einer Nullabweichung des Ausgangssignales Δf des Frequenzdiskriminators 10, womit der PLL-LOCK-Detektor 11 ein Stellsignal U_{SCH} zum Schließen des Analogschalters 16 abgibt.

Der Mikroprozessor 17 startet daraufhin eine Fangroutine mit welcher die Mittenfrequenz f₀ des YIG-Oszillators 1 und der ihr zugeordnete Fangbereich ΔFM der Frequenzregelschleife gezielt verschoben wird, bis die neue Betriebsfrequenz f_{SOLL} in den Fangbereich ΔFM fällt. Die Oszillator-Mittenfrequenz f₀ ist die Ausgangsfrequenz des YIG-Oszillators 1, die sich als Funktion des eingestellten Spulenstromes I_{SP} in der Hauptabstimmspule 13 und bei stromloser FM-Spule 14 (I_{FM} = 0) unter dem Einfluß von Alterung und Hysterese einstellt. Der Fangbereich ΔFM der Frequenzregelschleife liegt symmetrisch um diese Oszillator-Mittenfrequenz f₀ und ist begrenzt durch den maximal möglichen Betrag des Spulenstromes I_{FM} in der FM-Spule 14, der wiederum durch den endlichen Spannungsbereich - Uₘₐₓ < U_{FM} < + Uₘₐₓ am Ausgang des Schleifenfilters 9 gegeben ist. Da sich die Frequenzregelschleife vor und zu Beginn der Fangroutine im ausgerasteten Zustand befindet, liegt die Ausgangsspannung UFM des Schleifenfilters 9 an der positiven oder negativen Spannungsbegrenzung des als Integrator geschalteten Schleifenfilters 9 und demzufolge stellt sich bei einem eingeprägten Spulenstrom I_{SP} zunächst keine eindeutige Istfrequenz f ein, vielmehr kann die Istfrequenz f entweder am oberen oder unteren Rand des um die gedachte Oszillator-Mittenfrequenz f₀ zentrierten Fangbereiches ΔFM auftreten. Fällt beim Ablauf der Fangroutine die neue Betriebsfrequenz f SOLL in den mit dem Spulenstrom I_{SP} verschobenen Fangbereich ΔFM, dann zieht die Frequenzregelschleife die Istfrequenz f des YIG-Oszillators 1 auf die neue Betriebsfrequenz f_{SOLL}.

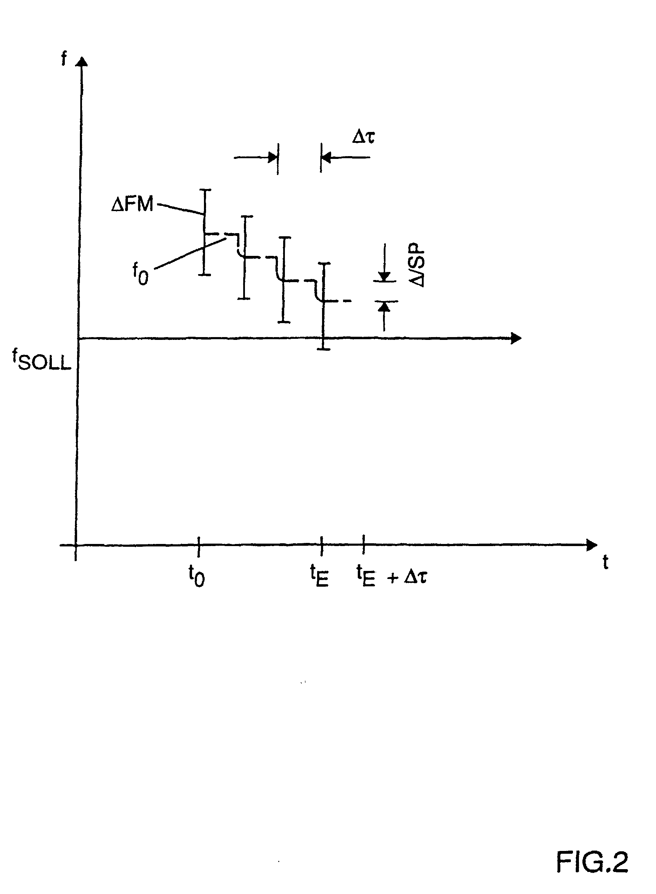

Fig.2 zeigt den zeitlichen Ablauf einer Fangroutine. Die Fangroutine besteht hier in einer sukzessiven Erniedrigung der Oszillator-Mittenfrequenz f₀ des YIG-Oszillators 1, gesteuert vom Mikroprozessor 17, der über den D/A-Wandler 18 und den nachgeschalteten U-I-Konverter 12 der Hauptabstimmspule 13 den Spulenstrom I_{SP} aufprägt.

Die Fangroutine startet zum Zeitpunkt t₀ mit einer Istfrequenz f, die bei Berücksichtigung der aus Erfahrung für einen bestimmten YIG-Oszillator-Typ anzunehmenden maximalen Kennlinienabweichung infolge von Alterung und Hysterese mit Sicherheit über der neuen Betriebsfrequenz f_{SOLL} liegt.Der undefinierte Zustand der Istfrequenz f in den einzelnen Iterationsschritten ist für jeden Iterationsschritt mit einem balkenförmig gezeichneten Fangbereich ΔFM angedeutet, an dessen oberer oder unterer Grenze sich die Istfrequenz f befindet. Die gedachte Oszillator-Mittenfrequenz f₀ ist in Fig.2 als gestrichelte Linie dargestellt. An der dargestellten Oszillator Mittenfrequenz f₀ läßt sich die relative Größe der Spulenstromschritte ΔISP im Vergleich zum Fangbereich ΔFM und die Taktdauer Δτ der Fangroutine aufzeigen. Der Mikroprozessor 17 erniedrigt, ausgehend von einem anfänglichen Startwert, den Spulenstrom I_{SP} so lange um konstante, aneinandergrenzende Spulenstromschritte, die Frequenzschritte ΔISP zur Folge haben, bis das von dem Mikroprozessor 17 überwachte Ausgangssignal U_{D} des PLL-LOCK-Detektors 11 den Signalzustand "HIGH" annimmt. Dazu muß ein sich mit dem Spulenstrom I_{SP} verlagernder Fangbereich ΔFM der Frequenzregelschleife die neue Betriebsfrequenz f_{SOLL} einschließen - in Fig.2 ist dieser Zeitpunkt mit t_{E} gekennzeichnet - und die Istfrequenz f von der eingeschalteten Frequenzregelschleife innerhalb der Taktdauer Δτ in den Fangbereich der PLL und von dieser auf die neue Betriebsfrequenz f_{SOLL} gezogen sein. Die Spulenstromschritte sind erfindungsgemäß so ausgelegt, daß die damit bewirkten Frequenzschritte ΔISP am Ausgang des YIG-Oszillators 1 kleiner sind als der Fangbereich ΔFM der Frequenzregelschleife.

Für einen handelsüblichen YIG-Oszillator im X-Band kann die voranstehend beschriebene Fangroutine mit einem Spulenstrom I_{SP} gestartet werden, der gemäß Kennlinie des YIG-Oszillators 1 eine Oszillator-Mittenfrequenz f₀ bewirkt, die etwa um 40 MHz über der neuen Betriebsfrequenz f_{SOLL} liegt. Dieser Frequenzwert wird sich aber nicht einstellen, da die Istfrequenz durch Alterung und Hysterese beeinflußt ist und deshalb von der Kennlinie abweicht. Bei einem im X-Band typischen Fangbereich ΔFM der Frequenzregelschleife von 4 MHz ist für den erfindungsgemäß kleineren Spulenstromschritt ein Wert geeignet, der zu einem Frequenzschritt ΔISP von 3,5 MHz führt. Damit wird ausgehend von dem oberen Startwert ein darunterliegender Frequenzbereich lückenlos abgedeckt. Die Taktdauer Δt der Fangroutine kann etwa 10 ms betragen. Die voranstehenden Werte sind nur als Beispielwerte angegeben und können vom Fachmann beliebig den jeweiligen Gegebenheiten angepaßt werden, ohne daß es dazu einer erfinderischen Tätigkeit bedarf.

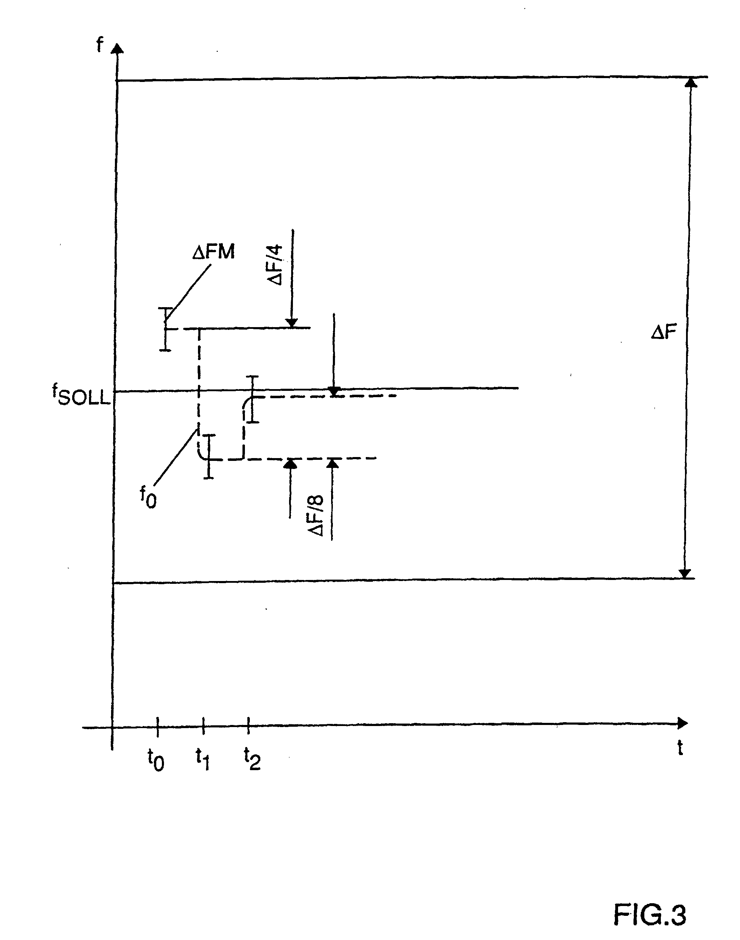

In Fig.3 ist eine andere, erfindungsgemäße Ausbildung einer Fangroutine gezeigt. In dieser Fangroutine wird abweichend zu der vorangehend beschriebenen Fangroutine mit sich ändernden Spulenstromschritten gearbeitet. Die Schrittweite wird von Iterationschritt zu Iterationsschritt halbiert und die Verstellrichtung der Spulenstromschritte ist abhängig von dem Vorzeichen der in dem vorangehenden Iterationsschritt verbliebenen Frequenzabweichung. Zur Ermittlung dieses Vorzeichens wird das Ausgangssignal Δf des Frequenzdiskriminators 10 ausgewertet, das diese Information enthält.

Die Fangroutine startet zum Zeitpunkt t₀ mit einem Spulenstrom I_{SP} , der gemäß Kennlinie des YIG-Oszillators 1 zu einer Oszillator-Mittenfrequenz f₀ führt, die der neuen Betriebsfrequenz f_{SOLL} entspricht. Infolge von Alterung und Hysterese wird sich diese Frequenz nicht einstellen. Für die Beschreibung der Fangroutine ist hier angenommen, daß sich eine Istfrequenz oberhalb der neuen Betriebsfrequenz f_{SOLL} einstellt. Eine negative Frequenzabweichung könnte aber ebensogut eintreten. Die Istfrequenz ist wie voranstehend beschrieben bei ausgerasteter Frequenzregelschleife nicht definiert und wird sich innerhalb des Fangbereiches ΔFM am unteren oder oberen Rand dieses Bereiches einstellen. Der Einstellungsbereich der Istfrequenzen in den einzelnen Iterationsschritten ist mit Balken dargestellt. Der Iterationschritt zum Zeitpunkt t₁ wird mit einem Spulenstromschritt eingeleitet, dessen Wert 1/4 der Spulenstromdifferenz beträgt, die einem angenommenen Einrastbereich ΔF entspricht, der symmetrisch um die zuerst eingestellte Oszillator-Mittenfrequenz f₀ liegt. Die Größe dieses Einrastbereiches ΔF ist so festgelegt, daß für einen bestimmten YIG-Oszillator-Typ die neue Betriebsfrequenz f_{SOLL} auf jeden Fall innerhalb dieses Einrastbereiches ΔF liegt, wenn im ersten Iterationsschritt eine Istfrequenz f mit dem Wert der neuen Betriebsfrequenz f_{SOLL} eingestellt wird.

Der Spulenstromschritt zum Zeitpunkt t₁ wird wegen der beispielhaft angenommenen vorangehenden positiven Frequenzabweichung erfindungsgemäß mit umgekehrtem, hier also negativem Vorzeichen ausgeführt. Die Information für die Vorzeichenwahl erhält der Mikroprozessor 17 von dem PLL-LOCK-Detektor 11. Der PLL-LOCK-Detektor 11 ist für den Einsatz in dieser Fangroutine mit zwei binären, zueinander komplementären Signalausgängen ausgerüstet, von denen einer den Signalzustand "HIGH" bei positivem und der andere bei negativem Ausgangssignal ΔF des Frequenzdiskriminators 10 annimmt. Für das Ausgangssignal ΔF = 0 sind die Ausgänge nicht mehr komplementär; es gehen dann beide Ausgänge auf den Signalzustand "LOW".

Wenn nach Ausführung des vorangehenden Spulenstromschrittes weiterhin eine Frequenzabweichung besteht, was in dem in Fig.3 gezeigtem Fall angenommen ist, dann wird der nächste Spulenstromschritt zum Zeitpunkt t₂ mit der halben Schrittweite des vorangehenden Schrittes ausgeführt. Sein Wert beträgt 1/8 der Spulenstromdifferenz, die dem Einrastbereich ΔF entspricht. Das Vorzeichen dieses Schrittes ist positiv, da im vorangehenden Iterationsschritt ein negative Frequenzabweichung verblieben ist. Mit der Ausführung dieses Spulenstromschrittes soll hier angenommen sein, daß der Fangbereich ΔFM der Frequenzregelschleife die neue Betriebsfrequenz f_{SOLL} einschließt. Die eingangs der Fangroutine über den Analogschalter 16 eingeschaltete Frequenzregelschleife zieht die Istfrequenz f in den Fangbereich der PLL, welche wiederum die Istfrequenz f auf die neue Betriebsfrequenz f_{SOLL} zieht. Sollte der Fangbereich ΔFM zum Zeitpunkt t₂ noch nicht die neue Betriebsfrequenz f_{SOLL} einschließen, dann wird die Fangroutine mit einer weiteren Halbierung der Spulenstromschritte und der von dem Ausgangssignal abhängigen Vorzeichenumkehr fortgesetzt. Die vorangehend beschriebene Fangroutine hat den Vorteil, daß die Istfrequenz f damit in wenigen Iterationsschritten sehr schnell an die neue Betriebsfrequenz f _{SOLL} herangeführt ist, so daß die Regelschleifen einrasten.

Für den Betrieb eines YIG-Oszillators im X-Band kann für einen möglichen Einrastbereich ΔF ein Wert von 20 MHz angenommen werden. Dieser Wert ist abhängig von dem jeweiligen Bauelementetyp des YIG-Oszillators.

Wenn die Istfrequenz f auf die neue Betriebsfrequenz f_{SOLL} gezogen ist generiert der PLL-LOCK-Detektor 11 ein Schaltsignal U_{SCH} mit dem der Analogschalter 16 geöffnet wird. Damit ist die Frequenzregelschleife aufgetrennt, denn das Ausgangssignal ΔF des Frequenzdiskriminators 10 gelangt nicht mehr in den Gegenkopplungszweig des Schleifenfilters 9. Diese Abschaltfunktion ist optional und nicht unbedingt erforderlich, da bei Eintritt der Istfrequenz f in den Fangbereich der PLL diese gegenüber der Frequenzregelschleife wegen ihrer wesentlichen größeren Gleichstromverstärkung dominiert. Das Abschalten der Frequenzregelschleife hat den Vorteil, daß die PLL nicht durch das Rauschen der Frequenzregelschleife gestört wird.

Eine Alterung des YIG-Oszillators 1 bewirkt in erster Linie eine Nullpunktsverschiebung des linearen Zusammenhangs zwischen dem Spulenstrom I_{SP} und der Istfrequenz f. Die Steigung dieser Kennlinie bleibt davon unberührt. Diese Eigenschaft der Alterung ermöglicht es, daß der Mikroprozessor 17 im eingerasteten Zustand der PLL den durch Alterung bedingten Offset der Istfrequenz f ermittelt, abspeichert und bei einem angeforderten Frequenzwechsel für nachfolgende Fangroutinen berücksichtigt. Eine nachfolgende Fangroutine muß dann nur den Hysteresefehler berücksichtigen und läuft damit erheblich schneller ab.

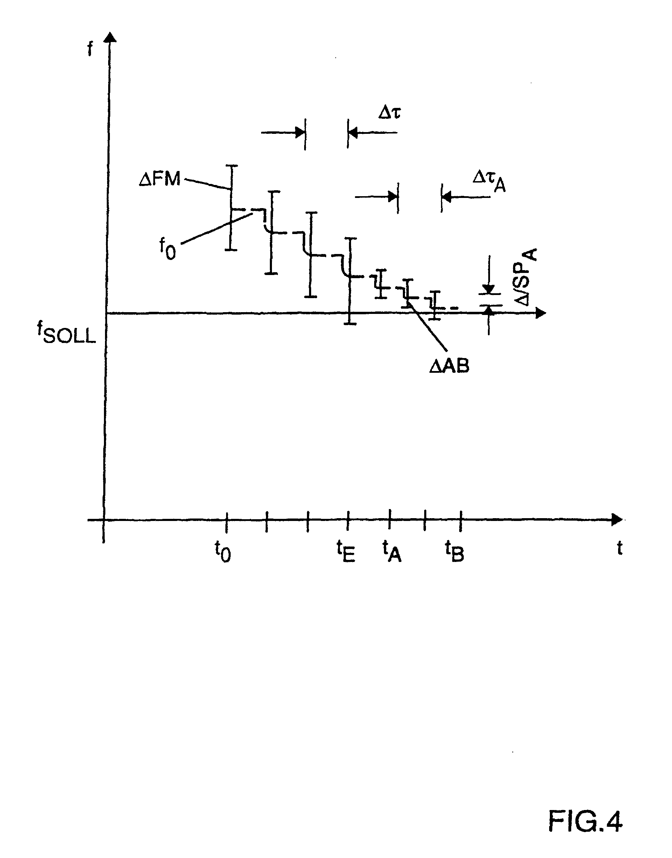

In Fig.4 ist gezeigt, wie im Anschluß an eine der vorangehend beschriebenen Fangroutinen eine optionale Abstimmroutine abläuft. Diese Abstimmroutine ist ebenfalls eine vom Mikroprozessor 17 gesteuerte, schrittweise Verstellung des Spulenstromes I_{SP} der Hauptabstimmspule 13 mit dem Ziel, den Spulenstrom I_{FM} der FM-Spule 14 in einen für den Operationsverstärker des Schleifenfilters 9 bevorzugten Arbeitsbereich zu bringen. In Fig.4 ist der bevorzugte Stromarbeitsbereich mit dem entsprechenden Frequenzbereich als Arbeitsfrequenzbereich ΔAB gezeigt. Die Verstellung des Spulenstromes I_{SP} in dieser Routine erfolgt in Abhängigkeit von den Ausgangssignalen des FM-Spulenstromüberwachers 19, der den Spulenstrom I_{FM} am Ausgang des Schleifenfilters 9 detektiert.

Der FM-Spulenstromüberwacher 19 ist als ein Fensterdiskriminator mit zwei binären Signalausgängen ausgerüstet, von denen einer den Signalzustand "HIGH" einnimmt, wenn der Spulenstrom I_{FM} einen oberen Schwellwert + I_{MAX} überschreitet und der andere bei Überschreitung eines unteren Schwellwertes - I_{MAX} in diesen Signalzustand geht. Befindet sich der Spulenstrom I_{FM} innerhalb des Fensters zwischen + I_{MAX} und - I_{MAX} , dann nehmen beide Signalausgänge den Signalzustand "LOW" an. In der Abstimmroutine wird in dem Ausführungsbeispiel der Spulenstrom I_{SP} mit Spulenstromschritten verstellt, deren Frequenzschritte ΔISP_{A} kleiner sind als die Frequenzschritte ΔISP in der vorangehenden Fangroutine. Ebenfalls ist für die Abstimmroutine auch eine kleinere Taktdauer Δτ_{A} gewählt. Die erfindungsgemäße Abstimmroutine ist aber auch mit anderen Spulenstromschritten und Taktdauern ausführbar.

Die Abstimmroutine startet zum Zeitpunkt t_{A} nach Ablauf des letzten Iterationsschrittes der Fangroutine. Bei detektierten Spulenströmen I_{FM} > + I_{MAX} werden Spulenstromschritte mit negativem Vorzeichen ausgeführt, d.h. die Oszillator-Mittenfrequenz f₀ wird erniedrigt, und bei detektierten Spulenströmen I_{FM} < - I_{MAX} erfolgt eine Verstellung des Spulenstromes I_{SP} in entgegengesetzter Richtung. Weisen beide Signalausgänge des FM-Spulenstromüberwachers 19 den Zustand "LOW" auf dann, ist wird die Abstimmroutine vom Mikroprozessor 17 beendet. In Fig.4 ist dafür der Zeitpunkt t_{B} angenommen.

Beim Betrieb des auf die neue Betriebsfrequenz f_{SOLL} eingerasteten YIG-Oszillator 1 kann infolge einer Drift des YIG-Oszillators die Wirkung der PLL durch einen zu hohen Spulenstrom I_{FM} beeinträchtigt sein, mit dem diese die Drift kompensiert. Damit der Spulenstrom I_{FM} im Arbeitsbereich des Schleifenfilters 9 bleibt, wird vom Mikroprozessor 17 optional eine Driftroutine gestartet, die mit denselben Mitteln wie die oben beschriebenen Abstimmroutine ausgeführt ist : FM-Spulenstromüberwacher 19 als Fensterdiskriminator mit den Schwellwerten + I_{MAX} und - I_{MAX}, Frequenzschritten ΔISP_{A}, Taktdauer Δτ_{A}, Vorzeichenumkehr für die Frequenzschritte bei zu großen oder zu kleinen Spulenströmen I_{FM .} Die PLL kommt dabei nicht aus dem Tritt, weil die vom Mikroprozessor 17 initierten Frequenzschritte nicht schlagartig, sondern mit einer gewissen Zeitkonstante im ms-Bereich einsetzen. Der Einsatz dieser Driftroutine ist optional und hängt von der zu erwartenden Drift des verwendeten YIG-Oszillatortyps und von dem Schleifenfiltertyp ab.

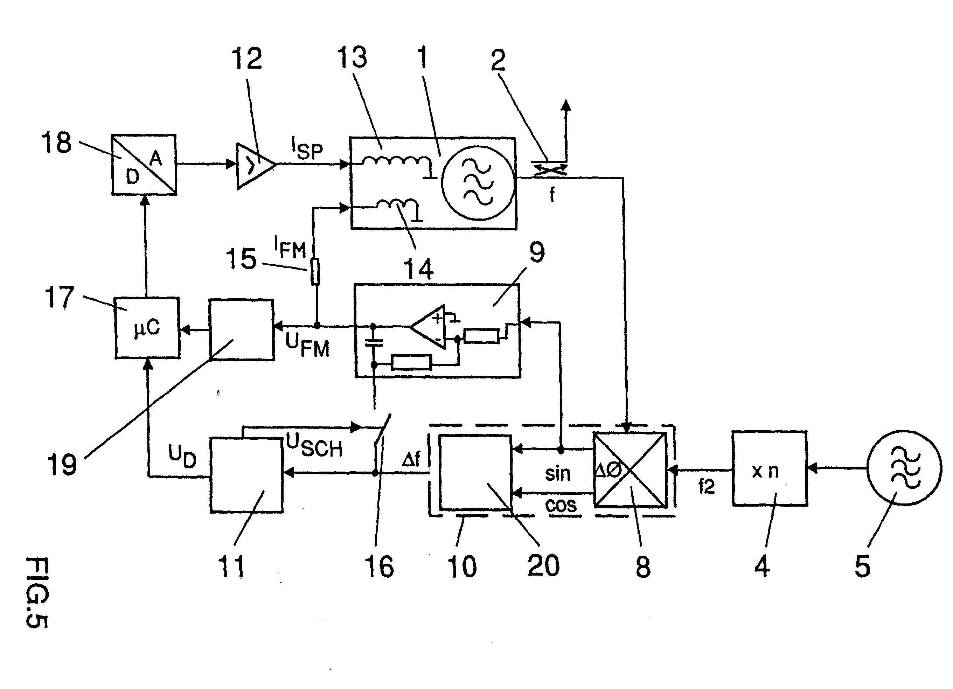

In Fig.5 ist eine Anordnung zur Durchführung des erfindungsgemäßen Verfahrens gezeigt, in welcher im Vergleich zu der in Fig.1 gezeigten Anordnung der YIG-Oszillator 1 nur an einen Quarzoszillator 5 angebunden ist. Diese Anordnung entspricht ansonsten der in Fig.1 gezeigten Anordnung und der zugehörigen Beschreibung. Mit dem zweiten Quarzoszillator 6 entfällt in dieser Anordnung auch der Frequenzmischer 3, da das Ausgangssignal des YIG-Oszillators 1 nach dem Durchlaufen der Auskoppelstufe 2 als Istfrequenz f direkt auf den Phasenkomparator 8 des Frequenzdiskriminators 10 gegeben ist. Mit dem Quarzoszillator 6 entfällt auch der DDS 7.

In dieser Anordnung existiert in Abweichung von der in Fig.1 beschriebenen Anordnung nur eine neue Betriebsfrequenz f_{SOLL}. In der Anordnung gemäß Fig.1 entstehen am Ausgang des Frequenzmischers 3 zwei Seitenbänder, die zu den beiden neuen Betriebsfrequenzen f_{SOLL} = n ∗ f1 +/- f2 ^{·} führen.

Die Anordnung gemäß Fig.5 mit nur einer neuen Betriebsfrequenz hat den Vorteil, daß ohne Probleme auch die Fangroutine nach Fig.3 angewendet werden kann, bei welcher der Spulenstrom I_{SP} an der neuen Betriebsfrequenz f_{SOLL} startet. Bei der Anordnung mit zwei neuen Betriebsfrequenzen f _{SOLL} kann bei der Fangroutine nach Fig.3 die Istfrequenz f auf eine falsche neue Betriebsfrequenz f_{SOLL}einrasten, wenn der Einrastbereich ΔF wegen der Berücksichtigung einer Alterung und Hysterese zu groß gewählt werden muß. In so einem Fall müßte die Fangroutine nach Fig.2 Anwendung finden, mit der sichergestellt ist, daß die Istfrequenz f definitiv auf die obere neue Betriebsfrequenz f_{SOLL} = n * f1 + f2 einrastet.

## Patentansprüche

1. Verfahren zum Einrasten einer Phasenregelschleife (PLL) um einen YIG-Oszillator, dessen Frequenz mittels einer mit einem Frequenzdiskriminator bestückten Frequenzregelschleife in den Fangbereich der PLL hineingeführt ist, wobei die Frequenzregelschleife nach erfolgter Einrastung der PLL abschaltbar ist, **dadurch gekennzeichnet, daß** bei einem vorgegebenen Frequenzwechsel die Voreinstellung der Frequenz des YIG-Oszillators (1) mittels eines Mikroprozessors (17) erfolgt, der den Spulenstrom (I_{SP}) der Hauptabstimmspule (13) des YIG-Oszillators (1) in einer iterativen Fangroutine schrittweise verändert, bis der sich mit dem Spulenstrom (I_{SP}) verlagernde Fangbereich (ΔFM) der eingeschalteten Frequenzregelschleife die neue Betriebsfrequenz (f_{SOLL}) einschließt, woraufhin die eingeschaltete Frequenzregelschleife die Oszillatorfrequenz in den Fangbereich der PLL zieht und die PLL die Oszillatorfrequenz auf die neue Betriebsfrequenz (f_{SOLL}) einrastet und daß der Mikroprozessor(17) die Fangroutine abbricht, wenn ein PLL-LOCK-Detektor (11) das erfolgte Einrasten auf die neue Betriebsfrequenz (f_{SOLL}) dem Mikroprozessor (17) meldet.

2. Verfahren nach Anspruch 1, **dadurch gekennzeichnet, daß** die Fangroutine mit einem Spulenstrom (I_{SP}) startet, der sicherstellt, daß auch unter Berücksichtigung der maximal möglichen Kennlinienabweichung infolge von Alterung und Hysterese die Istfrequenz (f) des YIG-Oszillators (1) über der neuen Betriebsfrequenz (f_{SOLL}) liegt, daß der Mikroprozessor (17) den Spulenstrom (I_{SP}) in gleichmäßigen, aneinandergrenzenden Schritten verringert bis der Fangbereich (ΔFM) der Frequenzregelschleife die neue Betriebsfrequenz (f_{SOLL}) einschließt und die Istfrequenz (f) durch die Regelschleifen innerhalb der Taktdauer (Δτ)der Fangroutine auf die neue Betriebsfrequenz (f_{SOLL}) einrastet, und daß die Größe der durch die Spulenstromschritte bewirkten Frequenzschritte (ΔISP) kleiner ist als der Fangbereich (ΔFM) der Frequenzregelschleife.

3. Verfahren nach Anspruch 1, **dadurch gekennzeichnet, daß** die Fangroutine mit einem Spulenstrom (I_{SP}) startet, der gemäß der Oszillator-Kennlinie der neuen Betriebsfrequenz (f_{SOLL}) zugeordnet ist, daß bei einer durch Alterung und Hytserese bedingten Abweichung der Istfrequenz der Mikroprozessor (17) den Spulenstrom (I_{SP}) für einen folgenden, zweiten Iterationsschritt um ein Viertel eines vorgegebenen Einrastbereiches (ΔF) verstellt, wobei bei einer positiven Frequenzabweichung der anfängliche Spulenstrom (I_{SP}) um diesen Wert erniedrigt und bei einer negativen Frequenzabweichung um diesen Wert erhöht wird, daß bei einer weiterbestehenden Abweichung in weiteren Iterationsschritten der Spulenstrom (I_{SP}) immer wieder um die Hälfte des vorangehenden Verstellbetrages je nach Vorzeichen der Abweichung in der vorangehend beschriebenen Weise erhöht oder erniedrigt wird, bis der Fangbereich (ΔFM) der Frequenzregelschleife die neue Betriebsfrequenz (f_{SOLL}) einschließt.

4. Verfahren nach einem der Ansprüche 1 bis 3, **dadurch gekennzeichnet, daß** der Mikroprozessor 17 vor einem Frequenzwechsel den bei einem vorangehenden Frequenzwechsel durch Alterung bedingten Offset der Istfrequenz (f) ermittelt hat, abspeichert und diesen Wert beim anstehenden Frequenzwechsel auf die neue Betriebsfrequenz (f_{SOLL}) bei der Festsetzung des Startwertes für den Spulenstrom (I_{SP}) berücksichtigt.

5. Verfahren nach einem der Ansprüche 1 bis 4, **dadurch gekennzeichnet, daß** der Mikroprozessor (17) direkt im Anschluß an die beendete Fangroutine eine Abstimmroutine für die FM-Spule (14) anschließt, in der in Abhängigkeit von dem Ausgangssignal eines FM-Spulenstromüberwachers (19), der den Spulenstrom (I_{FM}) der FM-Spule (14) detektiert und an den Mikroprozessor (17) meldet, mittels einer iterativen Verstellung des Spulenstromes (I_{SP}) der Hauptabstimmspule (13) der Spulenstrom (I_{FM}) der FM-Spule (14) durch den Mikroprozessor (17) in einen bevorzugten Arbeitsbereich gesteuert ist, dessen zugehöriger Frequenzbereich sich als Arbeitsfrequenzbereich (ΔAB) in seiner Ausdehnung einen Teil des Fangbereiches (ΔFM) des Frequenzregelkreises einnimmt.

6. Verfahren nach Anspruch 5, **dadurch gekennzeichnet, daß** der Spulenstrom (I_{SP}) der Hauptabstimmspule (13) in gleichmäßigen Schritten verstellt wird, die gleichmäßige Frequenzschritte (ΔISP_{A}) zur Folge haben und daß die Verstellung mit einer Taktdauer (Δτ_{A}) erfolgt, die kleiner als die Taktdauer (Δt) der Fangroutine ist.

7. Verfahren nach einem der Ansprüche 1 bis 6, **dadurch gekennzeichnet, daß** nach erfolgter Abstimmung des YIG-Oszillators (1) auf die neue Sollfrequenz eine auftretende Drift des YIG-Oszillators (1) mittels der FM-Spule (14) ausgeregelt wird, indem der Mikroprozessor (17) den Spulenstrom (I_{SP}) der Hauptabstimmspule (13) in Abhängigkeit von dem Ausgangssignal eines FM-spulenstromüberwachers (19), der den Spulenstrom (I_{FM}) der FM-Spule (14) detektiert, so steuert, daß sich der infolge der Drift ausgewanderte Spulenstrom (I_{FM}) der FM-Spule (14) wieder in seinem Arbeitsfrequenzbereich (ΔAB) befindet.

8. Verfahren nach einem der Ansprüche 1 bis 7, **dadurch gekennzeichnet, daß** der Mikroprozessor (17) beim ersten Durchlaufen der Fangroutine den infolge von Alterung und Hysterese bedingten Offset ermittelt, abspeichert und beim nächsten Starten der Fangroutine bei der Festsetzung des Startwertes für den Spulenstrom (I_{SP}) der Hauptabstimmspule (13) berücksichtigt.

9. Anordnung zur Durchführung des Verfahrens nach einem der vorangehenden Ansprüche, **dadurch gekennzeichnet,**
- **daß** ein vorgebbarer Teil des Ausgangsignales des YIG-Oszillators (1) mittels einer Auskoppelstufe (2) in einem Frequenzdiskriminator (10) mit einer Referenzfrequenz verglichen ist ,
- **daß** das Ausgangssignal (Δf) des Frequenzdiskriminators (10) in den Gegenkopplungszweig eines als Integrator ausgebildeten Schleifenfilters (9) gegeben ist, dessen Ausgangsstrom direkt als Spulenstrom (I_{FM}) zur Regelung des Magnetfeldes der FM-Spule (13) des YIG-Oszillators (1) benutzt ist,
- **daß** der Spulenstrom (I_{SP}) der Hauptabstimmspule (13) des YIG-Oszillators (1) von einem U-I-Konverter (12) erzeugt ist, der über einen D-A-Wandler (18) von einem Mikroprozessor (17) gesteuert ist, - daß das Ausgangssignal (Δf) des Frequenzdiskriminators (10) von einem PLL-LOCK-Detektor (11) detektiert ist, der sein Ausgangssignal (U_{D}) an den Mikroprozessor (17) abgibt,
- **daß** aus einem Phasenkomparator (8) des Frequenzdiskriminators (10) ein Inphase-Signal (sin) abgezweigt und auf den Eingang des Schleifenfilters (9) gegeben ist.

10. Anordnung nach Anspruch 9, **dadurch gekennzeichnet, daß** das Ausgangssignal des PLL-LOCK-Detektors (11) binär ist und seinen Zustand ändert, wenn das Ausgangssignal (Δf) des Frequenzdiskriminators (10) den Wert "Null" annimmt.

11. Anordnung nach Anspruch 9, **dadurch gekennzeichnet, daß** der PLL-LOCK-Detektor (11) zwei miteinander gekoppelte, binäre Signalausgänge aufweist, die in entgegengesetzter Weise die Zustände LOW und HIGH annehmen und diese Zustände ändern, wenn der Ausgang (Δf) des Frequenzdiskriminators (10) seinen Wert von "größer als Null" auf einen Wert "kleiner als Null" ändert.

12. Anordnung nach einem der Ansprüche 9, 10 und 11, **dadurch gekennzeichnet**, daßdas Ausgangsignal (U_{FM}) des Schleifenfilters (9) von einem FM-Spulenstromüberwacher (19) überwacht ist, der zwei binäre Signalausgänge aufweist, von denen einer den Zustand HIGH einnimmt, wenn der Wert des Ausgangssignal (U_{FM}) des Schleifenfilters (9) einen oberen Grenzwert (+ U_{MAX}) überschreitet und der andere den Zustand HIGH einnimmt, wenn der Wert des Ausgangs (U_{FM}) des Schleifenfilters (9) einen unteren Grenzwert (- U_{MAX}) unterschreitet.

13. Anordnung nach einem der Ansprüche 9 bis 12, **dadurch gekennzeichnet, daß** der YIG-Oszillator (1) an zwei Quarzoszillatoren (5,6) angebunden ist, von denen einer der Quarzoszillatoren (5) seine Frequenz (f1) über einen einstellbaren Frequenzvervielfacher (4) auf einen Frequenzmischer (3) gibt, in dem mit dem Ausgangssignal des YIG-Oszillators (1) ein Schwebungssignal (IF) gebildet ist, das zusammen mit einer Referenzfrequenz auf die Eingänge des Frequenzdiskriminators (10) gegeben ist und daß diese Referenzfrequenz die Ausgangsfrequenz (f2) eines einstellbaren Direkten Digitalen Synthesizers (7) ist, der von dem anderen Quarzoszillator (6) gespeist ist.

14. Anordnung nach einem der Ansprüche 9 bis 12, **dadurch gekennzeichnet, daß** der YIG-Oszillator (1) nur an einen Quarzoszillator (6) angebunden ist, dessen Frequenz auf einen einstellbaren Frequenzvervielfacher (4) gegeben ist und nach der Vervielfachung als Referenzfrequenz zum Vergleich mit dem Ausgangssignal des YIG-Oszillators (1) auf den Frequenzdiskriminator (10) gegeben ist.

15. Anordnung nach einem der Ansprüche 9 bis 14, **dadurch gekennzeichnet, daß** das Ausgangssignal (Δf) des Frequenzdiskriminators (10) mit einem Analogschalter (16) von dem Gegenkopplungszweig des Schleifenfilters (9) getrennt ist, wenn der PLL-LOCK-Detektor (11) nach erfolgter Einrastung des YIG-Oszillators (1) auf eine neue Betriebsfrequenz ein Schaltsignal (U_{SCH}) an den Analogschalter abgibt.

## Claims

1. Method for locking-in a phase locked loop (PLL) around a YIG oscillator, whose frequency is moved into the catchment range of the PLL by means of a frequency locked loop which is fitted with a frequency discriminator, in which case the frequency locked loop can be switched off once the PLL has been locked-in, **characterized in that**, when a predetermined frequency change takes place, the frequency of the YIG oscillator (1) is preset by means of a microprocessor (17), which changes the coil current (I_{SP}) in the main tuning coil (13) of the YIG oscillator (1) step-by-step in an iterative catching routine, until the catchment range (ΔFM), which is changed by the coil current (I_{SP}) in the switched-on frequency locked loop, includes the new operating frequency (f_{NOM}), at which point the switched-on frequency locked loop draws the oscillator frequency into the catchment range of the PLL, and the PLL locks the oscillator frequency in to the new operating frequency (f_{NOM}), and **in that** the microprocessor (17) terminates the catchment routine when a PLL-LOCK detector (11) signals to the microprocessor (17) that the process of locking in to the new operating frequency (f_{NOM}) has been completed.

2. Method according to Claim 1, **characterized in that** the catchment routine starts with a coil current (I_{SP}) which ensures that, even taking account of the maximum possible characteristic error resulting from ageing and hysteresis, the actual frequency (f) of the YIG oscillator (1) is above the new operating frequency ( f_{NOM}) , **in that** the microprocessor (17) reduces the coil current (I_{SP}) in uniform, mutually adjacent steps until the catchment range (ΔFM) of the frequency locked loop includes the new operating frequency ( f_{NOM}) and the actual frequency (f) locks in to the new operating frequency (f_{NOM}), by means of the control loops, within the clock duration (Δτ) of the catchment routine, and **in that** the magnitude of the frequency steps (ΔISP) resulting from the coil current steps is less than the catchment range (ΔFM) of the frequency locked loop.

3. Method according to Claim 1, **characterized in that** the catchment routine starts with a coil current (I_{SP}) which is associated with the new operating frequency (f_{NOM}) on the basis of the oscillator characteristic, **in that**, in the event of any error in the actual frequency caused by ageing and hysteresis, the microprocessor (17) adjusts the coil current (I_{SP}) by one quarter of a predetermined locking-in range (ΔF) for a subsequent, second iteration step, in which case, if the frequency error is positive, the initial coil current (I_{SP}) is reduced by this value and, if the frequency error is negative, it is increased by this value, **in that**, if there is still an error in further iteration steps, the coil current (I_{Sp}) is repeatedly increased or reduced in the manner described above by half the preceding adjustment amount, depending on the mathematical sign of the error, until the catchment range (ΔFM) of the frequency locked loop includes the new operating frequency (f_{NOM)}.

4. Method according to one of Claims 1 to 3, **characterized in that**, before a frequency change, the microprocessor (17) has determined the offset in the actual frequency (f) caused by ageing in a preceding frequency change, stores this offset and takes this value into account when fixing the start value for the coil current (I_{SP}) for a frequency change which is to take place to a new operating frequency (f_{NOM}).

5. Method according to one of Claims 1 to 4, **characterized in that**, as soon as the catchment routine has been ended, the microprocessor (17) immediately starts a tuning routine for the FM coil (14) in which the coil current (I_{FM}) in the FM coil (14) is controlled by the microprocessor (17) so as to be within a preferred operating range, by means of iterative adjustment of the coil current (I_{SP}) in the main tuning coil (13), as a function of the output signal from an FM coil current monitor (19) which detects the coil current (I_{FM}) in the FM coil (14) and signals this to the microprocessor (17), in which the extent of the frequency range which is associated with this preferred operating range occupies a portion of the catchment range (ΔFM) of the frequency locked loop, as the operating frequency range (ΔAB).

6. Method according to Claim 5, **characterized in that** the coil current (I_{SP}) in the main tuning coil (13) is adjusted in uniform steps which result in uniform frequency steps (ΔISP_{A}), and **in that** the adjustment process is carried out with a clock duration (Δτ_{A}) which is shorter than the clock duration (Δτ) of the catchment routine.

7. Method according to one of Claims 1 to 6, **characterized in that**, once the YIG oscillator (1) has been tuned to the new nominal frequency, any drift which occurs in the YIG oscillator (1) is regulated out by means of the FM coil (14), by the microprocessor (17) controlling the coil current (I_{SP}) in the main tuning coil (13) as a function of the output signal from an FM coil current monitor (19) which detects the coil current (I_{FM}) in the FM coil (14), such that the coil current (I_{FM}) in the FM coil (14) which has wandered as a consequence of the drift is once again located in its operating frequency range (ΔAB).

8. Method according to one of Claims 1 to 7, **characterized in that**, on the first run through the catchment routine, the microprocessor (17) determines the offset caused by ageing and hysteresis, stores this offset, and takes this value into account when fixing the start value for the coil current (I_{SP}) in the main tuning coil (13) when the catchment routine is next started.

9. Arrangement for carrying out the method according to one of the preceding claims, **characterized**
- **in that** a portion, which can be predetermined, of the output signal from the YIG oscillator (1) is compared with a reference frequency, by means of an output stage (2) in a frequency discriminator (10),
- **in that** the output signal (Δf) from the frequency discriminator (10) is passed into the negative feedback path of a loop filter (9) which is in the form of an integrator and whose output current is used directly as the coil current (I_{FM}) for regulating the magnetic field of the FM coil (13) for the YIG oscillator (1),
- **in that** the coil current (I_{SP}) in the main tuning coil (13) of the YIG oscillator (1) is produced by a U-I converter (12) which is controlled by a D-A converter (18) by a microprocessor (17)
- **in that** the output signal (Δf) from the frequency discriminator (10) is detected by a PLL-LOCK detector (11), which emits its output signal (U_{D}) to the microprocessor (17),
- **in that** an in-phase signal (sin) is tapped off from a phase comparator (8) in the frequency discriminator (10) and is passed to the input of the loop filter (9).

10. Arrangement according to Claim 9, **characterized in that** the output signal from the PLL-LOCK detector (11) is in binary form and changes its state when the output signal (Δf) from the frequency discriminator (10) assumes the value "zero".

11. Arrangement according to Claim 9, **characterized in that** the PLL LOCK detector (11) has two binary signal outputs, which are coupled to one another, assume the LOW and HIGH states in a mutually complementary manner and change these states when the output (Δf) of the frequency discriminator (10) changes its value from "greater than zero" to a value "less than zero".

12. Arrangement according to one of Claims 9, 10 and 11, **characterized in that** the output signal (U_{FM}) from the loop filter (9) is monitored by an FM coil current monitor (19) which has two binary signal outputs, one of which assumes the HIGH state when the value of the output signal (U_{FM}) from the loop filter (9) exceeds an upper limit value (+ U_{MAX}), and the other assumes the HIGH state when the value of the output (U_{FM}) of the loop filter (9) falls below a lower limit value (- U_{MAX}) .

13. Arrangement according to one of Claims 9 to 12, **characterized in that** the YIG oscillator (1) is linked to two crystal oscillators (5, 6), one of which crystal oscillators (5) passes its frequency (f1) via an adjustable frequency multiplier (4) to a frequency mixer (3) in which a beat signal (IF) is formed with the output signal from the YIG oscillator (1), which beat signal (IF) is passed together with a reference frequency to the inputs of the frequency discriminator (10), and **in that** this reference frequency is the output frequency (f2) of an adjustable direct digital synthesiser (7), which is fed by the other crystal oscillator (6).

14. Arrangement according to one of Claims 9 to 12, **characterized in that** the YIG oscillator (1) is linked to only one crystal oscillator (6), whose frequency is passed to an adjustable frequency multiplier (4) and, after being multiplied, is passed as the reference frequency to the frequency discriminator (10), for comparison with the output signal from the YIG oscillator (1).

15. Arrangement according to one of Claims 9 to 14, **characterized in that** the output signal (Δf) from the frequency discriminator (10) is separated by means of an analogue switch (16) from the negative feedback path of the loop filter (9) when, once the YIG oscillator (1) has been locked in to a new operating frequency, the PLL-LOCK detector (11) emits a switching signal (U_{SCH}) to the analogue switch.

## Revendications

1. Procédé pour synchroniser une boucle de régulation de phase (PLL) autour d'un oscillateur YIG, dont la fréquence est introduite dans la plage de capture de la PLL au moyen d'une boucle de régulation de la fréquence équipée d'un discriminateur de fréquence, dans lequel la boucle de régulation de fréquence peut être déconnectée après l'exécution de la synchronisation de la PLL, **caractérisé en ce que**, lors d'un changement de fréquence prédéterminé, on effectue le préréglage de la fréquence de l'oscillateur YIG (1) au moyen d'un microprocesseur (17), qui modifie pas à pas le courant de bobine (I_{SP}) de la bobine d'accord principale (13) de l'oscillateur YIG (1) dans une routine de capture itérative, jusqu'à ce que la plage de capture (ΔFM) de la boucle de régulation de la fréquence connectée se déplaçant avec le courant de bobine (I_{SP}) englobe la nouvelle fréquence de fonctionnement (f_{SOLL}), la boucle de régulation de la fréquence connectée attire ensuite la fréquence de l'oscillateur dans la plage de capture de la PLL et la PLL synchronise la fréquence de l'oscillateur sur la nouvelle fréquence de fonctionnement (f_{SOLL}) et **en ce que** le microprocesseur (17) interrompt la routine de capture, lorsqu'un détecteur PLL-LOCK (11) signale au microprocesseur (17) l'exécution de la synchronisation à la nouvelle fréquence de fonctionnement (f_{SOLL}).

2. Procédé suivant la revendication 1, **caractérisé en ce que** la routine de capture démarre avec un courant de bobine (I_{SP}), qui assure que même en tenant compte de l'écart maximal possible de la caractéristique par suite du vieillissement et de l'hystérésis, la fréquence réelle (f) de l'oscillateur YIG (1) est située au-dessus de la nouvelle fréquence de fonctionnement (f_{SOLL}), **en ce que** le microprocesseur (17) diminue le courant de bobine (I_{SP}) par des pas successifs réguliers jusqu'à ce que la plage de capture (ΔFM) de la boucle de régulation de la fréquence englobe la nouvelle fréquence de fonctionnement (f_{SOLL}) et synchronise la fréquence réelle (f) sur la nouvelle fréquence de fonctionnement (f_{SOLL}) par les boucles de régulation à l'intérieur de la durée d'impulsion (Δτ) de la routine de capture, et **en ce que** la grandeur des pas de fréquence (ΔI_{SP}) provoqués par les pas du courant de bobine est plus petite que la plage de capture (ΔFM) de la boucle de régulation de la fréquence.

3. Procédé suivant la revendication 1, **caractérisé en ce que** la routine de capture commence avec un courant de bobine (I_{SP}) qui est associé à la nouvelle fréquence de fonctionnement (f_{SOLL})conformément à la caractéristique de l'oscillateur, **en ce que**, lors d'un écart de la fréquence réelle provoqué par un vieillissement et une hystérésis, le microprocesseur (17) déplace le courant de bobine (I_{SP}) pour un deuxième pas d'itération suivant d'un quart d'une plage de synchronisation (ΔF) prédéterminée, le courant de bobine initial (I_{SP}) étant abaissé de cette valeur dans le cas d'un écart de fréquence positif et étant augmenté de cette valeur dans le cas d'un écart de fréquence négatif, **en ce que**, en cas d'écart persistant dans des pas d'itération-suivants, le courant de bobine (I_{SP}) est à nouveau abaissé ou augmenté de la moitié du montant de réglage précédent, selon le signe de l'écart, de la façon décrite plus haut, jusqu'à ce que la plage de capture (Δ_{FM}) de la boucle de régulation de la fréquence englobe la nouvelle fréquence de fonctionnement (f_{SOLL}).

4. Procédé suivant l'une quelconque des revendications 1 à 3, **caractérisé en ce que** le microprocesseur (17) a déterminé, avant un changement de fréquence, le décalage de la fréquence réelle (f) provoqué par le vieillissement lors d'un changement de fréquence précédent, l'a mémorisé et a tenu compte de cette valeur lors du prochain changement de fréquence à la nouvelle fréquence de fonctionnement (f_{SOLL}) lors de la fixation de la valeur de départ pour le courant de bobine (I_{SP}) .

5. Procédé suivant l'une quelconque des revendications 1 à 4, **caractérisé en ce que** le microprocesseur (17) relie directement à la suite de la routine de capture terminée une routine d'accord pour la bobine FM (14), dans laquelle, en fonction du signal de sortie d'un système de surveillance du courant de bobine FM (19), qui détecte le courant de bobine (I_{FM}) de la bobine FM (14) et le transmet au microprocesseur (17), le courant de bobine (I_{FM}) de la bobine FM (14) est réglé par le microprocesseur (17), au moyen d'un réglage itératif du courant de bobine (I_{SP}) de la bobine d'accord principale (13), dans une plage de travail préférée, dont la plage de fréquence associée occupe comme plage de fréquence de travail (ΔAB) dans son étendue une partie de la plage de capture (ΔFM) du circuit de régulation de la fréquence.

6. Procédé suivant la revendication 5, **caractérisé en ce que** le courant de bobine ( I_{SP}) de la bobine d'accord principale (13) est réglé en pas réguliers, qui provoquent des pas de fréquence réguliers (ΔISP_{A}) et **en ce que** le réglage est effectué avec une durée d'impulsion (Δτ_{A}), qui est plus petite que la durée d'impulsion (Δτ) de la routine de capture.

7. Procédé suivant l'une quelconque des revendications 1 à 6, **caractérisé en ce que**, après avoir accordé l'oscillateur YIG (1) sur la nouvelle fréquence de consigne, une dérive éventuelle de l'oscillateur YIG (1) est régulée au moyen de la bobine FM (14), par le fait que le microprocesseur (17) règle le courant de bobine (I_{SP}) de la bobine d'accord principale (13) en fonction du signal de sortie d'un système de surveillance du courant de bobine FM (19), qui détecte le courant de bobine (I_{FM}) de la bobine FM (14), de telle manière que le courant de bobine (I_{FM}) de la bobine FM (14) déréglé par suite de la dérive se trouve à nouveau dans sa plage de fréquence de travail (ΔAB).

8. Procédé suivant l'une quelconque des revendications 1 à 7, **caractérisé en ce que**, lors de la première exécution de la routine de capture, le microprocesseur (17) détermine le décalage provoqué par suite du vieillissement et de l'hystérésis, le mémorise et en tient compte lors du prochain démarrage de la routine de capture pour la fixation de la valeur de départ pour le courant de bobine (I_{SP}) de la bobine d'accord principale (13).

9. Dispositif pour la mise en oeuvre du procédé suivant l'une quelconque des revendications précédentes, **caractérisé en ce que**
- on compare une partie prédéterminée du signal de sortie de l'oscillateur YIG (1) à une fréquence de référence au moyen d'un étage de découplage (2) dans un discriminateur de fréquence (10),
- on envoie le signal de sortie (Δf) du discriminateur de fréquence (10) dans la branche de contre-couplage d'un filtre de boucle (9) configuré en intégrateur, dont le courant de sortie est utilisé directement comme courant de bobine (I_{FM}) pour la régulation du champ magnétique de la bobine FM (13) de l'oscillateur YIG (1),
- on produit le courant de bobine (I_{SP}) de la bobine d'accord principale (13) de l'oscillateur YIG (1) au moyen d'un convertisseur U-I (12), qui est commandé par un microprocesseur (17) via un convertisseur D-A (18),
- on détecte le signal de sortie (Δf) du discriminateur de fréquence (10) au moyen d'un détecteur PLL-LOCK (11), qui envoie son signal de sortie (U_{D}) au microprocesseur (17),
- on dérive un signal en phase (sin) hors d'un comparateur de phase (8) du discriminateur de fréquence (10) et on l'envoie à l'entrée du filtre de boucle (9).

10. Dispositif suivant la revendication 9, **caractérisé en ce que** le signal de sortie du détecteur PLL-LOCK (11) est binaire et change son état lorsque le signal de sortie (Δf) du discriminateur de fréquence (10) prend la valeur "zéro".

11. Dispositif suivant la revendication 9, **caractérisé en ce que** le détecteur PLL-LOCK (11) présente deux sorties de signaux binaires couplées l'une à l'autre, qui prennent les états LOW et HIGH à l'inverse l'une de l'autre et qui changent ces états, lorsque la sortie (Δf) du discriminateur de fréquence (10) change sa valeur de "supérieure à zéro" à "inférieure à zéro".

12. Dispositif suivant l'une quelconque des revendications 9, 10 et 11, **caractérisé en ce que** le signal de sortie (U_{FM}) du filtre de boucle (9) est surveillé par un système de surveillance du courant de bobine FM (19), qui présente deux sorties de signaux binaires, dont l'une occupe un état HIGH lorsque la valeur du signal de sortie (U_{FM}) du filtre de boucle (9) dépasse une valeur limite supérieure (+ U_{MAX}) et l'autre occupe un état HIGH, lorsque la valeur de la sortie (U_{FM}) du filtre de boucle (9) descend sous une valeur limite inférieure (- U_{MAX}).

13. Dispositif suivant l'une quelconque des revendications 9 à 12, **caractérisé en ce que** l'oscillateur YIG (1) est raccordé à deux oscillateurs à quartz (5, 6), dont l'un des oscillateurs à quartz (5) envoie sa fréquence (f1) via un multiplicateur de fréquence réglable (4) à un mélangeur de fréquence (3), dans lequel on forme avec le signal de sortie de l'oscillateur YIG (1) un signal de battement (IF) qui est envoyé avec une fréquence de référence sur les entrées du discriminateur de fréquence (10) et **en ce que** cette fréquence de référence est la fréquence de sortie (f2) d'un synthétiseur numérique direct réglable (7), qui est alimenté par l'autre oscillateur à quartz (6) .

14. Dispositif suivant l'une quelconque des revendications 9 à 12, **caractérisé en ce que** l'oscillateur YIG (1) n'est raccordé qu'à un seul oscillateur à quartz (6), dont la fréquence est envoyée à un multiplicateur de fréquence réglable (4) et est envoyée, après la multiplication, sur le discriminateur de fréquence (10) comme fréquence de référence pour une comparaison avec le signal de sortie de l'oscillateur YIG (1).

15. Dispositif suivant l'une quelconque des revendications 9 à 14, **caractérisé en ce que** le signal de sortie (Δf) du discriminateur de fréquence (10) est séparé de la branche de contre-couplage du filtre de boucle (9) avec un commutateur analogique (16), lorsque le détecteur PLL-LOCK (11) envoie un signal de commutation (U_{SCH}) au commutateur analogique après l'exécution de la synchronisation de l'oscillateur YIG (1) à une nouvelle fréquence de fonctionnement.
